# EUROPEAN PATENT APPLICATION

(11) **EP 3 358 381 A1**
(43) Date of publication of application: **08.08.2018**
(21) Application number: 16850650.9
(22) Date of filing: 26.09.2016
(51) Int. Cl.: G02B 5/20, F21S 2/00, F21V 7/22, F21V 9/16, H01L 33/50, H01S 5/022

(54) **WAVELENGTH CONVERSION ELEMENT AND LIGHT EMITTING DEVICE**

(30) Priority: 29.09.2015 JP 2015192328
(71) Applicant: Panasonic Intellectual Property Management Co., Ltd., Osaka-shi, Osaka 540-6207 (JP)
(72) Inventor: YAMANAKA, Kazuhiko, Osaka-shi, Osaka 540-6207 (JP); KASUGAI, Hideki, Osaka-shi, Osaka 540-6207 (JP); NAGASAKI, Yoshihisa, Osaka-shi, Osaka 540-6207 (JP); HAMADA, Takahiro, Osaka-shi, Osaka 540-6207 (JP)
(74) Representative: Appelt, Christian W.
(86) International application number: PCT/JP2016/004333
(87) International publication number: WO 2017/056470

(57) **Abstract**

A wavelength conversion element (1) includes a support member (2) having a supporting surface (2a), and a wavelength converter (4) disposed above the supporting surface (2a). The wavelength converter (4) contains first fluorescent particles (4a) which absorb excitation light (82) and generate fluorescence (second radiation light (91)), and a transparent binder (4b) which bonds the first fluorescent particles (4a), and has a joint surface (7) facing supporting surface (2a), and an incident surface (6) disposed opposite to the joint surface (7), the excitation light entering the incident surface (6). The excitation light (82) and fluorescence are emitted from the incident surface (6). The wavelength converter (4) includes projections (5a). At least part of the projections (5a) is disposed on the incident surface (6). The first fluorescent particles (4a) are partially exposed from vertices of the projections (5a).

## Description

### TECHNICAL FIELD

The present disclosure relates to wavelength conversion elements and light emitting devices including wavelength conversion elements.

### BACKGROUND ART

Light emitting devices including wavelength conversion elements have been proposed in the related art (for example, see PTL 1). As an example of such light emitting devices, the light emitting device disclosed in PTL 1 will be described with reference to FIG. 21. FIG. 21 is a schematic view of a conventional light emitting device.

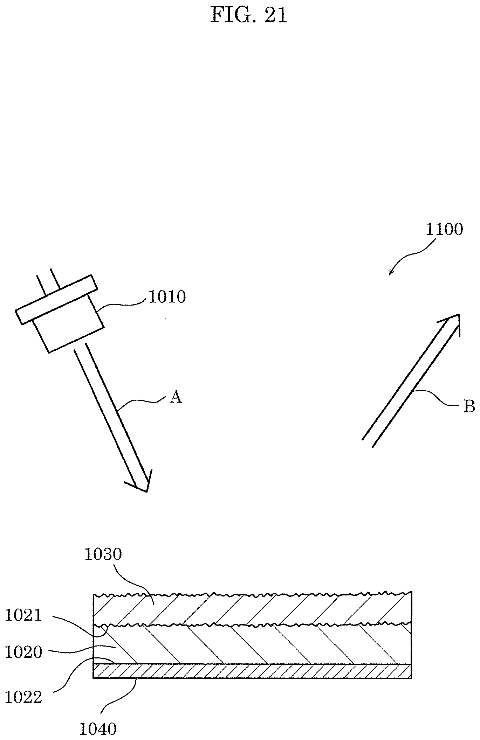

As illustrated in FIG. 21, light emitting device 1100 disclosed in PTL 1 includes light source 1010 which emits first light A, and wavelength conversion member 1020 which emits second light as fluorescence after first light A enters wavelength conversion member 1020 as excitation light. First main surface 1021 of wavelength conversion member 1020 is irradiated with first light A, and emits mixed color light B of first light A and second light. First main surface 1021 of wavelength conversion member 1020 includes light transmissive layer 1030 having a refractive index higher than that of wavelength conversion member 1020. The interface between wavelength conversion member 1020 and light transmissive layer 1030 has a rough surface. The interface between wavelength conversion member 1020 and light transmissive layer 1030 has a plurality of fine projections and depressions. The outer main surface of light transmissive layer 1030 (the upper main surface in FIG. 21) also has a plurality of similar fine projections and depressions. These fine projections and depressions are formed as follows: The surface of first main surface 1021 of wavelength conversion member 1020 is roughened by a process, such as abrasion, and light transmissive layer 1030 is formed on the roughened first main surface 1021 by sputtering or chemical vapor deposition (CVD). Second main surface 1022 opposite to first main surface 1021 of wavelength conversion member 1020 includes reflective member 1040.

In light emitting device 1100 disclosed in PTL 1 including such a configuration, first light A and second light are scattered by the two main surfaces of light transmissive layer 1030 and first main surface 1021 of wavelength conversion member 1020.

### Citation List

### Patent Literature

PTL 1: Japanese Unexamined Patent Application Publication No. 2015-103539

### SUMMARY OF THE INVENTION

### TECHNICAL PROBLEM

Light emitting device 1100 disclosed in PTL 1 requires sufficient surface roughening of first main surface 1021 and the like to obtain sufficient scattering action in wavelength conversion member 1020 and light transmissive layer 1030. On the other hand, wavelength conversion member 1020 should have structural strength in order to perform roughening of first main surface 1021 and facilitate the handling of wavelength conversion member 1020 when wavelength conversion member 1020 is placed on the reflective member. For this reason, wavelength conversion member 1020 needs a certain degree of thickness. In other words, the shape of wavelength conversion member 1020 disclosed in PTL 1 is limited.

An object of the present disclosure is to provide a wavelength conversion element including a wavelength converter which can ensure sufficient scattering action and has high freedom of a shape, and a light emitting device including the wavelength conversion element.

### SOLUTIONS TO PROBLEM

To achieve the object, the wavelength conversion element according to the present disclosure is a wavelength conversion element, including: a support member having a supporting surface; and a wavelength converter disposed above the supporting surface, wherein the wavelength converter contains first fluorescent particles which absorb excitation light and generate fluorescence, and a transparent binder which bonds the first fluorescent particles, and has a joint surface facing the supporting surface, and an incident surface disposed opposite to the joint surface, the excitation light entering the incident surface, the excitation light and the fluorescence are emitted from the incident surface, the wavelength converter includes projections, at least part of the projections is disposed on the incident surface, and the first fluorescent particles are partially exposed from vertices of the projections.

### ADVANTAGEOUS EFFECT OF INVENTION

The present disclosure can provide a wavelength conversion element including a wavelength converter which can ensure sufficient scattering action and has high freedom of shape, and a light emitting device including the wavelength conversion element.

### BRIEF DESCRIPTION OF DRAWINGS

FIG. 1 is a schematic cross-sectional view of a wavelength conversion element according to Embodiment 1.
FIG. 2 is a diagram illustrating a function of the wavelength conversion element according to Embodiment 1.
FIG. 3 is a schematic perspective view of the wavelength conversion element according to Embodiment 1.
FIG. 4 is a schematic cross-sectional view of a configuration where the wavelength conversion element according to Embodiment 1 is fixed.
FIG. 5 is a schematic cross-sectional view illustrating the steps in a first half of the process of manufacturing the wavelength conversion element according to Embodiment 1.
FIG. 6 is a schematic cross-sectional view illustrating the steps in a second half of the process of manufacturing the wavelength conversion element according to Embodiment 1.
FIG. 7 is a diagram schematically illustrating a measuring system used in an experiment to verify the advantageous effects of the wavelength conversion element according to Embodiment 1.
FIG. 8 illustrates graphs of the results of the experiment to verify the advantageous effects of the wavelength conversion element according to Embodiment 1.
FIG. 9 is a schematic view of a light emitting device according to Embodiment 1.
FIG. 10 is a schematic view illustrating of an example of a configuration of a projector including the light emitting device according to Embodiment 1.
FIG. 11 is a schematic view illustrating another example of a configuration of a light emitting device including the wavelength conversion element according to Embodiment 1.
FIG. 12 is a schematic view illustrating another example of a configuration of a light emitting device including the wavelength conversion element according to Embodiment 1.
FIG. 13 is a schematic view illustrating another example of a configuration of a light emitting device including the wavelength conversion element according to Embodiment 1.
FIG. 14 is a schematic cross-sectional view illustrating a wavelength conversion element according to Modification 1 of Embodiment 1.
FIG. 15 is a diagram illustrating a process of manufacturing a wavelength conversion element according to Modification 1 of Embodiment 1.
FIG. 16 is a schematic cross-sectional view of a wavelength conversion element according to Modification 2 of Embodiment 1.
FIG. 17A is a schematic cross-sectional view illustrating a step before filling of a transparent binder in a process of manufacturing a wavelength conversion element according to Embodiment 2.
FIG. 17B is a schematic cross-sectional view illustrating a process of filling the transparent binder in the process of manufacturing the wavelength conversion element according to Embodiment 2.
FIG. 17C is a schematic cross-sectional view illustrating a step during filling of the transparent binder in the process of manufacturing the wavelength conversion element according to Embodiment 2.
FIG. 17D is a schematic cross-sectional view illustrating a step after the filling of the transparent binder in the process of manufacturing the wavelength conversion element according to Embodiment 2.
FIG. 18 is a schematic cross-sectional view of a wavelength conversion element according to Embodiment 3.
FIG. 19A is a schematic cross-sectional view illustrating a process of manufacturing a wavelength conversion element according to Embodiment 3.
FIG. 19B is a schematic cross-sectional view illustrating the process of manufacturing the wavelength conversion element according to Embodiment 3.
FIG. 19C is a schematic cross-sectional view illustrating the process of manufacturing the wavelength conversion element according to Embodiment 3;
FIG. 19D is a schematic cross-sectional view illustrating the process of manufacturing the wavelength conversion element according to Embodiment 3.
FIG. 19E is a schematic cross-sectional view illustrating the process of manufacturing the wavelength conversion element according to Embodiment 3.
FIG. 19F is a schematic cross-sectional view illustrating the process of manufacturing the wavelength conversion element according to Embodiment 3.
FIG. 20 is a schematic cross-sectional view of a wavelength conversion element according to a modification of Embodiment 3.
FIG. 21 is a schematic view of a conventional light emitting device.

### DESCRIPTION OF EXEMPLARY EMBODIMENTS

Embodiments will now be described with reference to the drawings. The following embodiments should not be construed as limitative to the present disclosure. The drawings are schematic or conceptual, and relations between thicknesses and widths of portions, ratios of sizes of portions, and the like are not always identical to actual relations and ratios in sizes. Even if substantially identical portions are represented, their sizes and/or ratios may be different depending on the drawings. Duplication of description of substantially identical configurations may be omitted in some cases. Among the components of the embodiments below, the components not described in an independent claim representing the most superordinate concept of the present disclosure are described as arbitrary components.

A variety of modifications of the present embodiment devised and made by persons skilled in the art the present disclosure without departing the gist of the present disclosure are also included in the present disclosure. At least part of a plurality of embodiments can be combined without departing the gist of the present disclosure.

In this specification, the term "above" does not represent an upper direction (vertically above) in an absolute spatial recognition, rather is used as a term specified by a relative positional relation based on the lamination order of a laminate configuration. The term "above" is used not only in cases where two components are spaced from each other at an interval by another component present between the two components, but also in cases where two components are disposed adjacent to and in contact with each other.

### (Embodiment 1)

The wavelength conversion element according to Embodiment 1 will now be described with reference to the drawings.

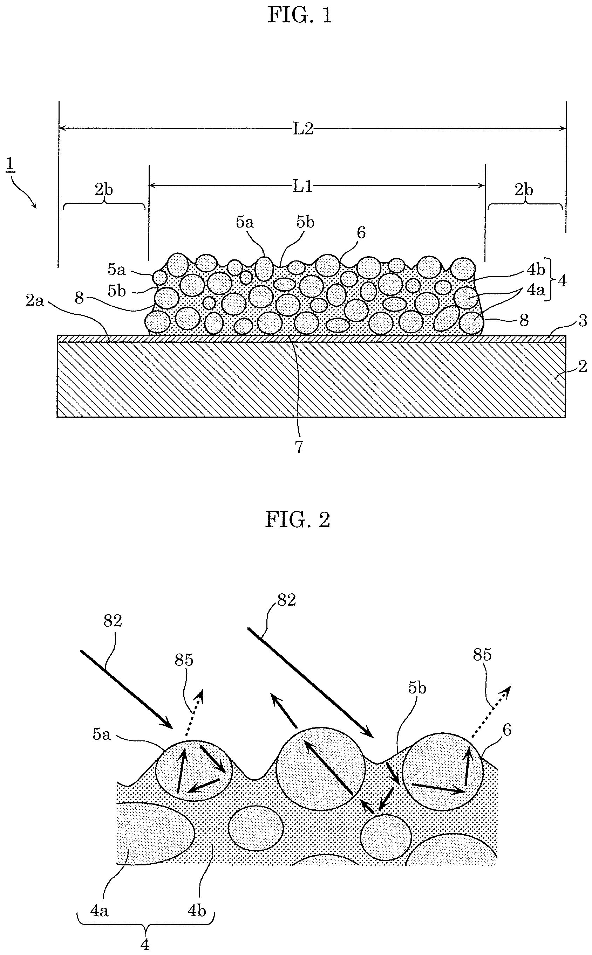

FIG. 1 is a schematic cross-sectional view of wavelength conversion element 1 according to the present embodiment.

As illustrated in FIG. 1, wavelength conversion element 1 according to the present embodiment includes support member 2 including supporting surface 2a, and wavelength converter 4 disposed above supporting surface 2a.

Wavelength converter 4 includes first fluorescent particles 4a which absorb excitation light and emit fluorescence, and transparent binder 4b which binds first fluorescent particles 4a, joint surface 7 facing supporting surface 2a, and incident surface 6 disposed opposite to joint surface 7, the excitation light entering incident surface 6. Incident surface 6 of wavelength converter 4 emits excitation light and fluorescence. Wavelength converter 4 includes projections 5a. At least part of projections 5a is disposed on incident surface 6. First fluorescent particles 4a are partially exposed from the vertices of projections 5a. Wavelength converter 4 includes depressions 5b. Transparent binder 4b is exposed in depressions 5b.

In other words, among the surfaces of wavelength converter 4, at least incident surface 6 of wavelength converter 4 includes projections 5a formed as a result of exposure of first fluorescent particles 4a, and depressions 5b formed as a result of exposure of transparent binder 4b. The surface of one first fluorescent particle 4a is exposed from the vertex of each of projections 5a. In other words, one first fluorescent particle 4a forms one projection 5a. Depressions 5b correspond to the surface of transparent binder 4b exposed between first fluorescent particles 4a.

The function of wavelength conversion element 1 having the configuration described above will be described with reference to FIG. 2.

FIG. 2 is a diagram illustrating the function of wavelength conversion element 1 according to the present embodiment.

In wavelength conversion element 1 according to the present embodiment, as illustrated in FIG. 2, excitation light 82 incident to incident surface 6 of wavelength converter 4 enters first fluorescent particles 4a or transparent binder 4b. In the present embodiment, laser light is used as excitation light 82. Near incident surface 6, there are interfaces between media having different refractive indices, that is, an interface between the air and wavelength converter 4 and an interface between first fluorescent particles 4a and transparent binder 4b. Incident surface 6 also has projections 5a formed of exposed surfaces of first fluorescent particles 4a and depressions 5b formed of exposed surfaces of transparent binder 4b between first fluorescent particles 4a. For this reason, excitation light 82 incident to wavelength converter 4 undergoes irregular reflection or multiple reflection on incident surface 6 as illustrated with the solid line in FIG. 2, and part of components of the light is radiated as first radiation light 85 (the arrow with a dotted line illustrated in FIG. 2) from wavelength converter 4. At this time, first radiation light 85 undergoes irregular reflection or multiple reflection by the interface present near incident surface 6. For this reason, first radiation light 85 has reduced directivity of excitation light 82 including laser light. The emitting direction of excitation light 82 incident to projections 5a and depressions 5b is varied according to the incident position. For this reason, wavelength conversion element 1 can radiate first radiation light 85 as light emitted in all directions. In other words, wavelength conversion element 1 according to the present embodiment can ensure sufficient scattering action. Wavelength converter 4 radiates part of components of excitation light 82 as fluorescence having a wavelength converted by first fluorescent particles 4a. The fluorescence will be described later.

The embodiment including non-essential, optional components will now be more specifically described.

As illustrated in FIG. 1, wavelength conversion element 1 includes reflective film 3 disposed on supporting surface 2a of support member 2. Reflective film 3 includes wavelength converter 4 disposed on the surface of reflective film 3. Wavelength converter 4 includes first fluorescent particles 4a, and transparent binder 4b which bonds first fluorescent particles 4a. First fluorescent particles 4a are preferably dispersed in transparent binder 4b.

First fluorescent particles 4a can be a yttrium-aluminum-garnet (YAG) fluorescent substance, such as (Ga, Y, Gd)₃Al₅O₁₀ doped with cerium (Ce) in the case where the excitation light is blue light having a wavelength of 420 nm to 490 nm. Besides, europium (Eu)-doped α-SiAlON or Eu-doped (Ba, Sr)Si₂O₂N₂ can be used according to the wavelength of the light radiated from the fluorescent substance.

Transparent binder 4b is preferably a transparent material containing silicon (Si) and oxygen (O) as main components. Examples thereof include glass, silsesquioxane, and silicone. Preferably, in wavelength converter 4, first fluorescent particles 4a are spaced from each other, and transparent binder 4b is filled into gaps between first fluorescent particles 4a.

To more efficiently absorb heat generated in wavelength conversion element 1, support member 2 is preferably formed of a material having high thermal conductivity and a small difference in coefficient of thermal expansion from that of transparent binder 4b. Specifically, a preferred material has a thermal conductivity of 100 W/mK or more and a coefficient of thermal expansion of 1 × 10⁻⁵/K or less. Specifically, examples of support member 2 include semiconductor crystal substrates, such as silicon carbide (SiC), sapphire (Al₂O₃), and aluminum nitride, or ceramic substrates.

Reflective film 3 is preferably formed of a material having high reflectance in the spectra of excitation light and fluorescence generated by first fluorescent particles 4a. Specifically, reflective film 3 is preferably formed of a metal film of aluminum (Al), silver (Ag), a silver alloy, or platinum (Pt), a dielectric film of SiO₂ or TiO₂, or a combination of a metal film and a dielectric film.

Shapes and sizes of wavelength converter 4 and support member 2 will now be described with reference to FIGs. 1, 3, and 4.

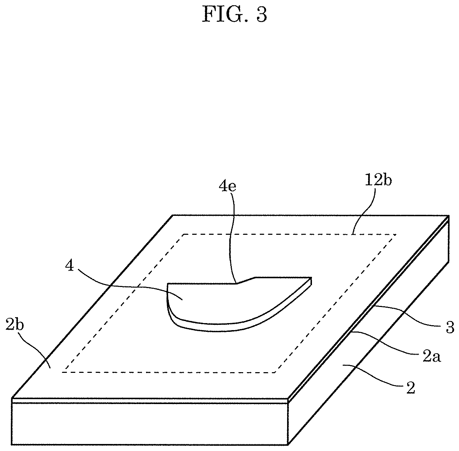

FIG. 3 is a schematic perspective view illustrating wavelength conversion element 1 according to the present embodiment. FIG. 3 is a perspective view of supporting surface 2a of support member 2 seen obliquely from above.

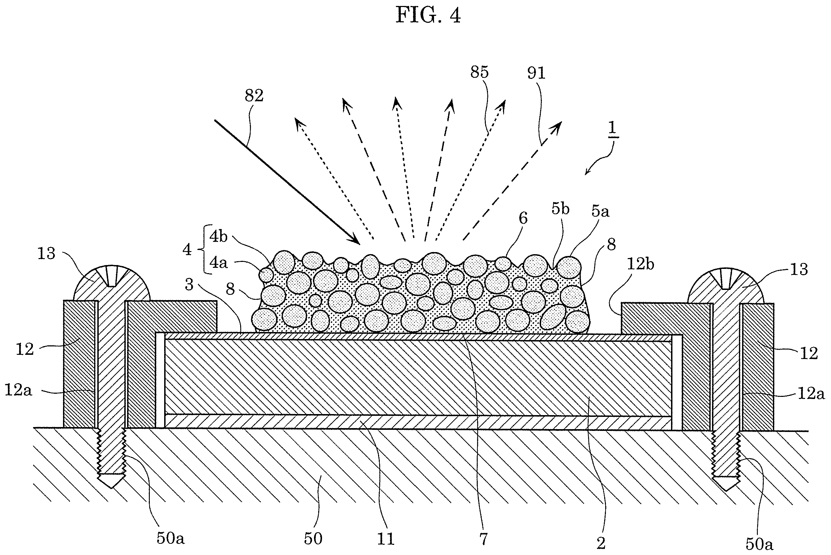

FIG. 4 is a schematic cross-sectional view illustrating a configuration where wavelength conversion element 1 according to the present embodiment is fixed.

As illustrated in FIG. 3, in the top surface view of supporting surface 2a, peripheral portion 2b of support member 2 is preferably exposed from wavelength converter 4. In other words, as illustrated in FIG. 1, width L1 of wavelength converter 4 is formed smaller than width L2 of support member 2 in wavelength conversion element 1. Formation of wavelength conversion element 1 as described above can facilitate fixation of wavelength conversion element 1 to a light emitting device in the case where wavelength conversion element 1 is used in the light emitting device. For example, as illustrated in FIG. 4, wavelength conversion element 1 is fixed to a predetermined position of fixing member 50. More specifically, fixing member 50 includes screw holes 50a. Wavelength conversion element 1 is disposed above fixing member 50 with contact member 11 interposed therebetween. Holding member 12 contacts peripheral portion 2b of support member 2 not including wavelength converter 4. Screws 13 are screwed through through holes 12a of holding member 12 into screw holes 50a disposed in fixing member 50. Wavelength conversion element 1 is fixed to fixing member 50 as described above. The position of end 12b of holding member 12 on the side of wavelength converter 4 in this case is indicated by the dotted line in FIG. 3. As illustrated in FIG. 3, end 12b is spaced from wavelength converter 4, and holding member 12 and wavelength converter 4 do not interfere with each other. Such a configuration can reduce damage of wavelength converter 4 caused by holding member 12.

As described above, wavelength converter 4 is disposed on support member 2 in wavelength conversion element 1 according to the present embodiment. For this reason, wavelength converter 4 can be handled using support member 2, avoiding the handling of wavelength converter 4 itself. Accordingly, wavelength conversion element 1 according to the present embodiment allows high freedom of shape of wavelength converter 4.

To absorb and dissipate heat generated in wavelength conversion element 1, fixing member 50 is preferably formed of a material having high thermal conductivity. Specifically, fixing member 50 is preferably formed of a material, such as aluminum, an aluminum alloy, or surface-plated copper or copper alloy. Contact member 11 has a function to quickly conduct heat from wavelength conversion element 1 to fixing member 50. Specifically, contact member 11 is formed of a graphite sheet, a heat-dissipating silicone resin, or a soldering material, for example.

Wavelength conversion element 1 fixed to fixing member 50 as described above is irradiated with excitation light 82, which is laser light having a peak wavelength of 450 nm, in the direction oblique to incident surface 6 as illustrated in FIG. 4, for example. At this time, part of excitation light 82 is absorbed by first fluorescent particles 4a in wavelength converter 4, is converted into fluorescence having a different wavelength, and is radiated from incident surface 6 as second radiation light 91 radiated in all directions.

Among the light components incident to wavelength converter 4, those not absorbed by first fluorescent particles 4a are reflected within wavelength converter 4 or on the surface thereof, and are radiated from wavelength converter 4 as first radiation light 85. At this time, the light components reflected within wavelength converter 4 undergo multiple reflection in first fluorescent particles 4a, and are radiated from the surface of wavelength converter 4. For this reason, the light components reflected within wavelength converter 4 are radiated from wavelength converter 4 as first radiation light 85 radiated from the surface thereof in all directions. The light components reflected on or near incident surface 6 of wavelength converter 4 and radiated as first radiation light 85 are also radiated after irregular reflection on projections 5a and depressions 5b of incident surface 6 of wavelength converter 4 or on the interface between first fluorescent particles 4a and transparent binder 4b which are present on incident surface 6. For this reason, the light components are radiated as first radiation light 85 radiated from incident surface 6 of wavelength converter 4 in all directions.

As the result above, mixed light of first radiation light 85 and second radiation light 91 radiated from incident surface 6 of wavelength converter 4 in all directions can be radiated. As illustrated in FIGs. 1 and 4, wavelength converter 4 includes lateral surface 8 intersecting joint surface 7 and incident surface 6. Part of excitation light 82 can enter lateral surface 8 of wavelength converter 4. In this case, first radiation light 85 and second radiation light 91 can be radiated from lateral surface 8. In the present embodiment, at least part of projections 5a and depressions 5b is disposed on lateral surface 8. For this reason, first radiation light 85 and second radiation light 91 which undergo irregular reflection are radiated from lateral surface 8. Thereby, the radiation light radiated from wavelength converter 4 can be more significantly scattered. Even when excitation light 82 is incident from incident surface 6, excitation light 82 and fluorescence, which enter deep inside wavelength converter 4, can cause the radiation of first radiation light 85 and second radiation light 91 from lateral surface 8.

As the result, wavelength converter 4 can emit white light having reduced unevenness in chromaticity distribution according by the emitting direction, where first radiation light 85 is blue light and second radiation light 91 is yellow light.

As illustrated in FIG. 3, in the top surface view of supporting surface 2a, the periphery of wavelength converter 4 according to the present embodiment has vertex 4e having an internal angle of more than 180 degrees. Because wavelength converter 4 is formed by bonding first fluorescent particles 4a with transparent binder 4b in the present embodiment, wavelength converter 4 having such a complex shape can be readily formed.

The process of manufacturing wavelength conversion element 1 described above will now be described. In the process of manufacturing wavelength conversion element 1 according to the present embodiment, a first wavelength conversion base containing a mixture of first fluorescent particles 4a and transparent binder 4b is formed on supporting surface 2a of support member 2. Subsequently, projections 5a and depressions 5b formed of first fluorescent particles 4a and transparent binder 4b are formed on the surface of the first wavelength conversion base.

Transparent binder 4b preferably contains silsesquioxane or zinc oxide. Transparent binder 4b used in the first wavelength conversion base according to the present embodiment is a transparent material containing silsesquioxane as a main component. In this case, the first wavelength conversion base is formed as follows: Fluorescent paste 24 of first fluorescent particles 4a dispersed in a transparent binder prepared by dissolving silsesquioxane in an organic solvent is applied onto support member 2. The coating of fluorescent paste 24 is fixed through a heat treatment. Projections 5a and depressions 5b formed of first fluorescent particles 4a and transparent binder 4b are then formed on the surface of first wavelength conversion base 4M by wet etching. As described above, wavelength conversion element 1 including wavelength converter 4 according to the present embodiment can be produced by a simple process.

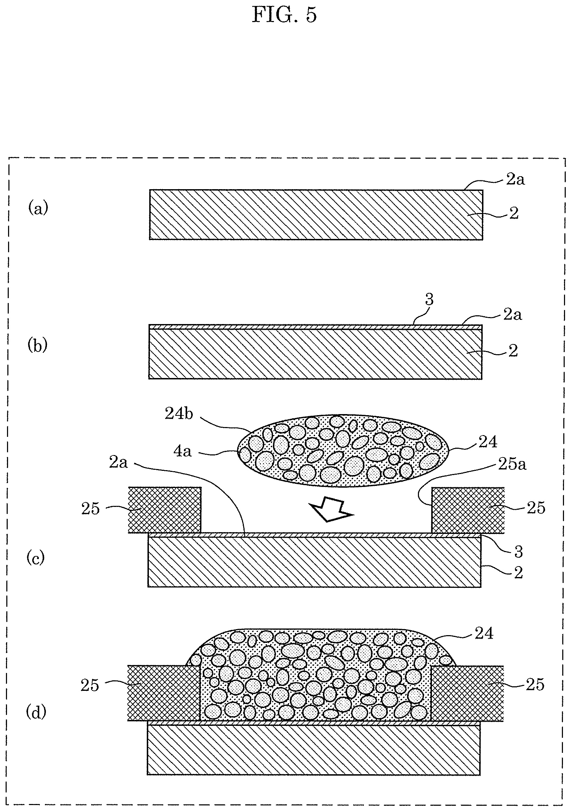

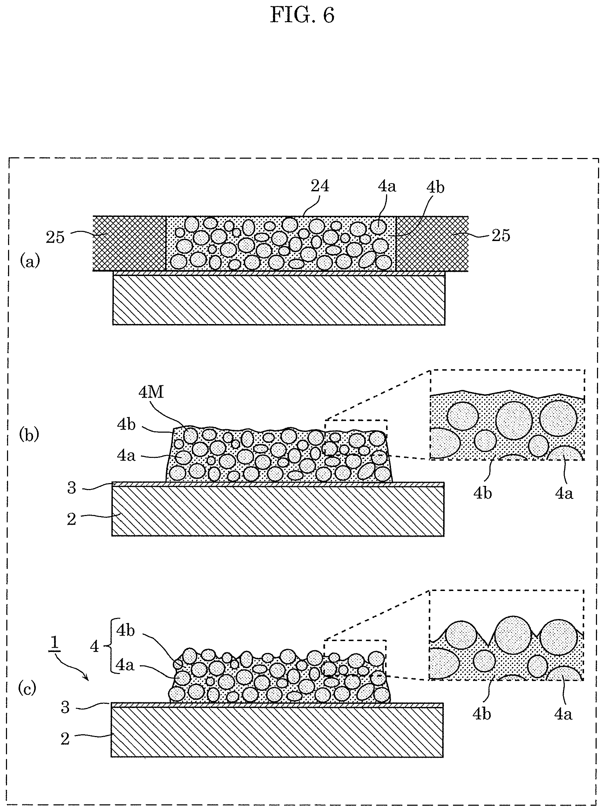

A specific process of manufacturing wavelength conversion element 1 including non-essential processes will now be described with reference to FIGs. 5 and 6.

FIG. 5 is a schematic cross-sectional view illustrating the steps in a first half of the process of manufacturing wavelength conversion element 1 according to the present embodiment.

FIG. 6 is a schematic cross-sectional view illustrating the steps in a second half of the process of manufacturing wavelength conversion element 1 according to the present embodiment.

Support member 2 is first prepared as illustrated in sectional view (a) of FIG. 5. In the present embodiment, an aluminum nitride ceramic substrate is prepared as support member 2.

Subsequently, as illustrated in sectional view (b) of FIG. 5, a silver alloy film formed of Ag, Pt, and Cu, and an SiO₂ film are formed in sequence through deposition to form reflective film 3 on supporting surface 2a, which is one of the main surfaces of support member 2.

Subsequently, as illustrated in sectional view (c) of FIG. 5, mask 25 having predetermined openings 25a is disposed above supporting surface 2a of support member 2. At this time, the shape of wavelength converter 4 can be formed freely by use of openings 25a having a shape formed according to a desired shape of wavelength converter 4. The thickness of mask 25 with openings can be set according to a desired thickness of wavelength converter 4 of wavelength conversion element 1. Fluorescent paste 24 of first fluorescent particles 4a mixed with liquid transparent binder 24b is then injected into openings 25a of mask 25 with openings disposed above support member 2. At this time, as illustrated in sectional view (d) of FIG. 5, fluorescent paste 24 is disposed such that openings 25a are sufficiently filled with fluorescent paste 24.

As illustrated in sectional view (a) of FIG. 6, excess fluorescent paste 24 overflowing from openings 25a is then removed.

As illustrated in sectional view (b) of FIG. 6, mask 25 with openings is then removed. Fluorescent paste 24 having a predetermined shape, and support member 2 having fluorescent paste 24 formed on the surface thereof are heated in a high temperature furnace at a temperature of about 150°C for about two hours, for example. As a result, transparent binder 24b in fluorescent paste 24 is cured through dehydration condensation and dealkoxylation condensation to form first wavelength conversion base 4M containing first fluorescent particles 4a fixed within transparent binder 4b.

First wavelength conversion base 4M is then immersed in a buffered aqueous solution of hydrofluoric acid contained in a resin beaker, for example. As a result, as illustrated in sectional view (c) of FIG. 6, transparent binder 4b on the surface of first wavelength conversion base 4M is etched to form projections 5a and depressions 5b formed of first fluorescent particles 4a and transparent binder 4b. Here, the buffered aqueous solution of hydrofluoric acid to be used is a dilution of a mixed aqueous solution of 15% ammonium hydrogenfluoride, 28% ammonium fluoride, and 57% water, for example. Etching is performed in the aqueous solution under an environment at room temperature for about ten minutes. Finally, etched first wavelength conversion base 4M is washed with water, and is dried to produce wavelength conversion element 1 including wavelength converter 4.

In the description above, opening 25a is preferably smaller than support member 2. As a result, as illustrated in FIG. 1, wavelength converter 4 has width L1 smaller than width L2 of support member 2. Such a configuration facilitates handling of wavelength conversion element 1, and fixation of wavelength conversion element 1 with holding member 12.

In the step above, a plurality of wavelength converters 4 may be formed on a single support member 2, and may be finally formed into individual wavelength conversion elements 1 by a step of dividing support member 2. In part of projections 5a, the vertices may be coated with transparent binder 4b without first fluorescent particles 4a exposed from the vertices.

According to the manufacturing process described above, wavelength conversion element 1 can be readily manufactured which has projections 5a and depressions 5b formed of first fluorescent particles 4a and transparent binder 4b on the surface of wavelength converter 4.

Subsequently, the advantageous effects of the wavelength conversion element according to the present disclosure will be described based on the experimental data with reference to the drawings.

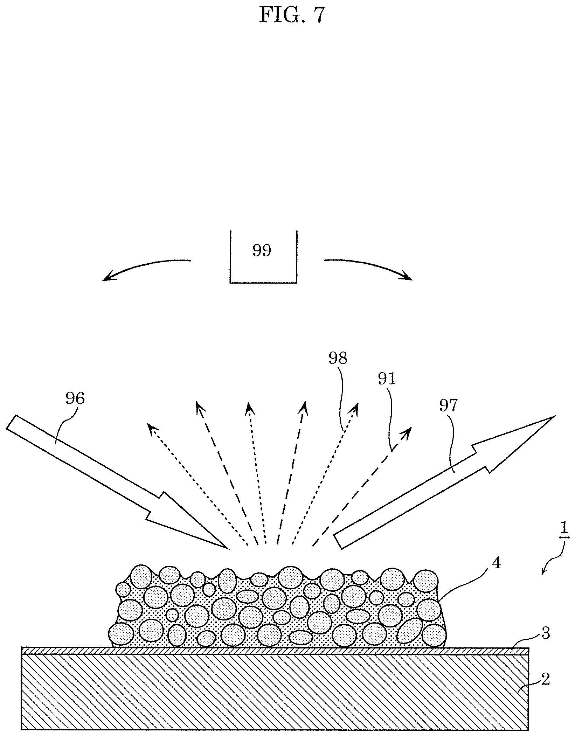

FIG. 7 is a diagram schematically illustrating a measuring system used in an experiment to verify the advantageous effects of wavelength conversion element 1 according to the present embodiment.

In this experiment, the measuring system illustrated in FIG. 7 was used. As illustrated in FIG. 7, laser light, i.e., excitation light 96 was caused to enter wavelength converter 4 of wavelength conversion element 1, the emitting angle dependency of the radiation light from wavelength converter 4 was measured with detector 99 which can detect an output according to the emitting direction of the radiation light. In this experiment, to verify the advantageous effects of wavelength conversion element 1 according to the present embodiment, the same measurement was performed on a wavelength conversion element according to Comparative Example (sample 1) in addition to wavelength conversion element 1 according to the present embodiment (sample 2). Unlike wavelength conversion element 1 according to the present embodiment, the wavelength conversion element according to Comparative Example includes a wavelength converter not surface-processed (or not etched). In other words, the wavelength conversion element according to Comparative Example (sample 1) includes first wavelength conversion base 4M according to the present embodiment as a wavelength converter. In contrast, wavelength converter 4 of wavelength conversion element 1 according to the present embodiment (sample 2) is prepared through etching of first wavelength conversion base 4M for ten minutes.

Excitation light 96 used in the experiment was laser light having a peak wavelength of 450 nm and having high directivity. The laser light was caused to enter the wavelength converter at an angle of 70 degrees with respect to the normal line of the incident surface of the wavelength converter. Here, first fluorescent particles 4a used were YAG fluorescent particles, which radiate fluorescence having a peak wavelength around 560 nm. First fluorescent particles 4a used had a particle diameter having a distribution in the range of 6 µm to 15 µm. Here, a particle diameter having a distribution in the range of 6 µm to 15 µm means that the average particle size (median diameter) D50 is 9 µm, the average particle size D10 is 6 µm, and the average particle size D90 is 15 µm. Transparent binder 4b is silsesquioxane. Each of the wavelength converters contains 60 vol% of first fluorescent particles 4a. The thickness of support member 2 of each of the wavelength converters is formed into 30 µm using the mask with openings in the manufacturing process described above. At this time, each of the wavelength converters has a thickness equal to the total thickness of three to four particles of first fluorescent particles 4a. The sizes of the depressions and projections on the surfaces of sample 1 and sample 2 were evaluated. The results show that the size of the depressions and projections in sample 1 had a peak to valley (P-V) value of less than 1 µm in a region of a 50 µm square. In sample 2, the size of the depressions and projections had a P-V value of 2 µm to 4 µm in the region of the same size. In other words, the size of depressions and projections in sample 1 corresponds to less than 2.2 times the peak wavelength of the excitation light while the size of the depressions and projections in sample 2 corresponds to 4.4 to 8.9 times the peak wavelength of the incident light. In short, incident surface 6 of wavelength converter 4 according to the present embodiment may have a region where the projections and depressions have a P-V value in the range of 4.4 to 8.9 times the peak wavelength of the excitation light. Incident surface 6 may have a region where the P-V value of the projections and depressions is in the range of 2 µm to 4 µm.

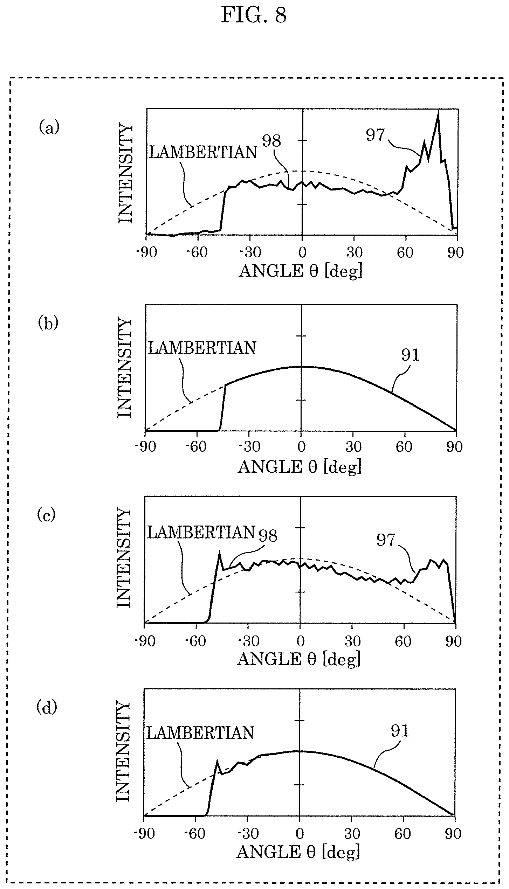

The results of the experiment performed on sample 1 and sample 2 using the measuring system will be described with reference to FIG. 8.

FIG. 8 illustrates graphs of the results of the experiment to verify the advantageous effects of wavelength conversion element 1 according to the present embodiment. Graph (a) and graph (b) of FIG. 8 show the emitting angle dependency of the radiation light having a wavelength of 450 nm and emitted from sample 1 and that of the radiation light having a wavelength of 560 nm and emitted from sample 1, respectively. Graph (c) and graph (d) of FIG. 8 show the emitting angle dependency of the radiation light having a wavelength of 450 nm and emitted from sample 2 and that of the radiation light having a wavelength of 560 nm and emitted from sample 2, respectively. As illustrated in FIG. 7, in the case where wavelength converter 4 is irradiated with excitation light 96 having high directivity, the light radiated from wavelength converter 4 is mainly classified into three types of the radiation light. The three components of the radiation light are first radiation light 97 which is reflected while keeping the directivity of excitation light 96, first radiation light 98 which is scattered in the wavelength converter and is radiated in all directions, and second radiation light 91 which is converted into fluorescence having a different wavelength in the wavelength converter and is radiated in all directions. In the case where ideal scattering light is radiated from the wavelength converter at this time, the scattering light is observed as emitted light having the same angle dependency as that of the light in Lambertian reflection represented by the dashed line in each graph of FIG. 8.

However, in the case of sample 1 including a surface including transparent binder 4b where first wavelength conversion base 4M has slight depressions and projections on its surface, first radiation light 97 keeping the directivity is also observed in addition to second radiation light 91 illustrated in graph (b) of FIG. 8 having the same angle distribution as that of the light in Lambertian reflection and first radiation light 98 illustrated in graph (a) of FIG. 8 radiated in all directions.

In contrast, in sample 2 including depressions and projections on the surface of wavelength converter 4 where projections 5a are formed of mainly first fluorescent particles 4a and depressions 5b are formed of mainly transparent binder 4b, first radiation light 97 keeping the directivity is significantly reduced as illustrated in graph (c) of FIG. 8. The intensity of first radiation light 98 near the radiation angle of 0 degrees in graph (c) of FIG. 8 is closer to that of the light in Lambertian reflection, compared to the result shown in graph (a) of FIG. 8. Accordingly, first radiation light 98 and first radiation light 97 illustrated in graph (c) of FIG. 8 can have the emitting angle dependency of the intensity of emitted light close to the emitting angle dependency of second radiation light 91 shown in graph (d) of FIG. 8. As a result, wavelength conversion element 1 can radiate white light having reduced unevenness in chromaticity distribution according to the emitting direction.

In graphs (a) to (d) of FIG. 8, the intensity of the emitted light is zero at a radiation angle in the range of -90° to -50°. This is caused because the radiation light cannot be observed due to the presence of an optical system for causing excitation light 96 to enter the wavelength converting element, and does not indicate the absence of the radiation light from the wavelength converter.

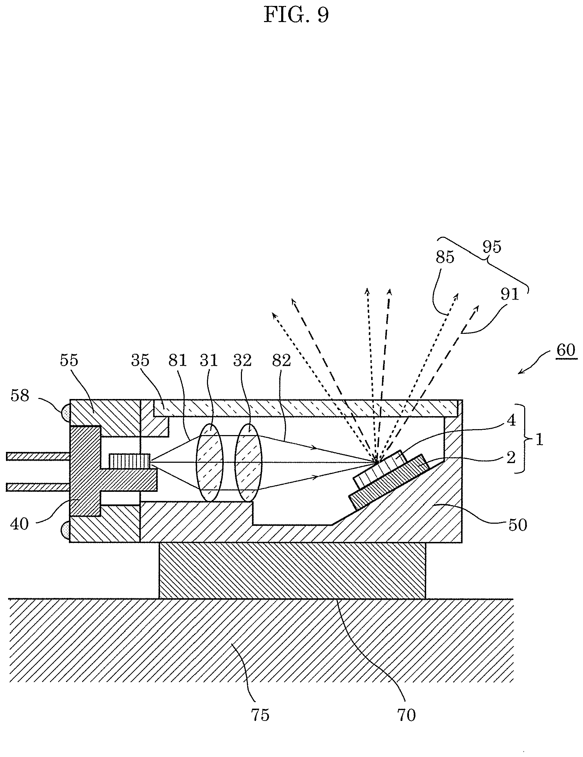

Light emitting device 60 including wavelength conversion element 1 described above will now be described with reference to FIG. 9.

FIG. 9 is a schematic view of light emitting device 60 according to the present embodiment.

As illustrated in FIG. 9, light emitting device 60 mainly includes wavelength conversion element 1, excitation light source 40, first lens 31, second lens 32, holder 55, fixing member 50, and heat dissipating mechanism 70.

Excitation light source 40 is a light source which radiates excitation light 82 (that is, excitation light 81) which enters wavelength conversion element 1. Excitation light source 40 is a semiconductor laser which radiates laser light having a wavelength of 390 nm to 500 nm, for example.

Holder 55 is a member which fixes excitation light source 40. Holder 55 also functions as a heat sink which absorbs and dissipates heat radiated from excitation light source 40. For this reason, holder 55 is preferably formed of a metal having high thermal conductivity, such as aluminum or an aluminum alloy. Excitation light source 40 is aligned with wavelength conversion element 1, and holder 55 is fixed to fixing member 50 with screws 58. Wavelength conversion element 1 is fixed to fixing member 50.

First lens 31 and second lens 32 are optical parts which are disposed between excitation light source 40 and wavelength conversion element 1, and converge excitation light 81. Excitation light 81 radiated from excitation light source 40 is converged into excitation light 82b through first lens 31 and second lens 32, and enters wavelength converter 4 of wavelength conversion element 1. First lens 31 and second lens 32 are fixed to fixing member 50.

Fixing member 50 is a member which fixes wavelength conversion element 1. Although the configuration where wavelength conversion element 1 is fixed is not illustrated in FIG. 9 for simplification, wavelength conversion element 1 fixed in such a configuration illustrated in FIG. 4 is preferred. In other words, wavelength conversion element 1 is preferably fixed to fixing member 50 with holding member 12 and screws 13. Fixing member 50 also functions a heat sink which absorbs and dissipates heat radiated from excitation light source 40 and wavelength conversion element 1. For this reason, fixing member 50 is preferably formed of a metal having high thermal conductivity, such as aluminum or an aluminum alloy.

Fixing member 50 includes transparent cover member 35 disposed to enclose the light path of excitation light 81 and excitation light 82. Transparent cover member 35 functions as a window through which radiation light is output from wavelength conversion element 1 to the outside.

Heat dissipating mechanism 70 is a base which fixes fixing member 50 to external fixing base 75 and conducts heat through fixing member 50 to external fixing base 75. Heat dissipating mechanism 70 is formed of a graphite sheet, for example. Heat dissipating mechanism 70 to be used may be an active heat dissipating mechanism, such as a Peltier device.

In such a configuration, excitation light 82 radiated from excitation light source 40 is scattered on the surface (incident surface 6) of wavelength converter 4 by projections 5a and depressions 5b formed of first fluorescent particles 4a and transparent binder 4b. For this reason, excitation light 82 is converted into first radiation light 85 and second radiation light 91 radiated in all directions in wavelength converter 4. First radiation light 85 and second radiation light 91 are then radiated as radiation light 95 of white light radiated from wavelength conversion element 1 upwardly in FIG. 9.

As described above, light emitting device 60 having a simplified configuration including wavelength conversion element 1 and excitation light source 40 can be achieved. Furthermore, support member 2 of wavelength conversion element 1 is fixed to fixing member 50, and fixing member 50 is connected to external fixing base 75. Such a configuration can facilitate conduction of heat generated in wavelength converter 4 through fixing member 50 and heat dissipating mechanism 70 to external fixing base 75. In other words, heat generated in wavelength converter 4 can be readily dissipated. Thus, a reduction in conversion efficiency caused by an increase in temperature of first fluorescent particles 4a can be prevented, achieving light emitting device 60 having high luminance. As described above, the present embodiment can achieve light emitting device 60 having small emitting angle dependency of chromaticity and having high luminance.

Light emitting device 60 can be used as headlamps for vehicles, for example. As illustrated in FIG. 3, wavelength converter 4 in wavelength conversion element 1 can have any shape in the top surface view. For this reason, among the headlamps for vehicles, the cutoff line of a low beam headlamp, for example, can be readily generated according to the shape of wavelength converter 4. To generate the cutoff line according to the shape of wavelength converter 4, vertex 4e having an internal angle of more than 180 degrees should be disposed in the periphery of wavelength converter 4 as illustrated in FIG. 3. Although it is generally difficult to form a substrate having vertex 4e having such a shape, wavelength converter 4 having such a shape can be readily formed in wavelength conversion element 1 according to the present embodiment.

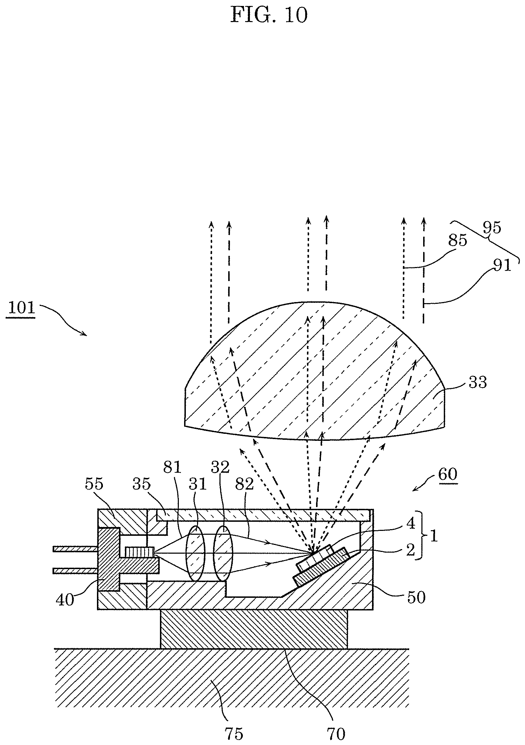

An example of a configuration of projector 101 which includes light emitting device 60 and can project radiation light will now be described with reference to FIG. 10.

FIG. 10 is a schematic view illustrating an example of a configuration of projector 101 including light emitting device 60 according to the present embodiment.

As illustrated in FIG. 10, projector 101 includes light emitting device 60, and projection lens 33 disposed in an emitting portion of light emitting device 60. In this configuration, light radiated from radiated from light emitting device 60 is converted into parallel light through projection lens 33. For this reason, projector 101 can radiate white light having high directivity. As a result, projector 101 can be achieved which has reduced unevenness in chromaticity distribution of radiation light and high intensity of the projection light.

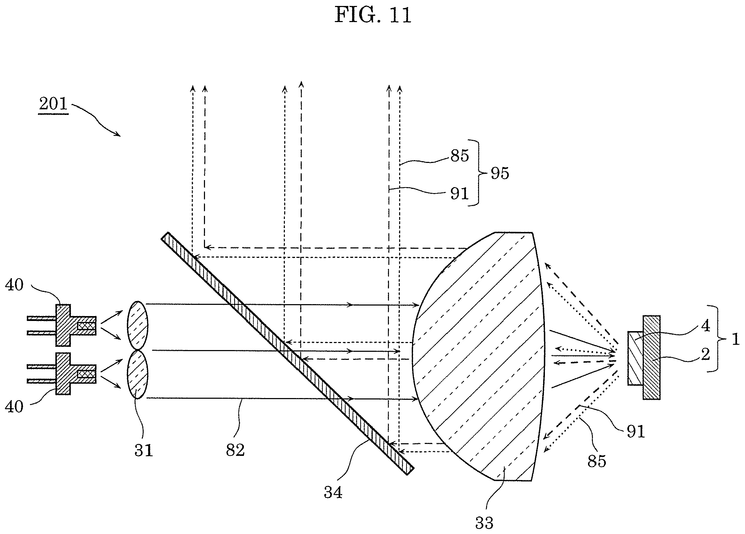

Light emitting device 201 or another example of the configuration of light emitting device according to the present disclosure will now be described with reference to FIG. 11.

FIG. 11 is a schematic view illustrating another example of the configuration of the light emitting device including wavelength conversion element 1 according to the present embodiment.

As illustrated in FIG. 11, light emitting device 201 having this example configuration includes a plurality of excitation light sources 40, dichroic mirror 34, first lens 31, projection lens 33, and wavelength conversion element 1.

In light emitting device 201 illustrated in FIG. 11, excitation light emitted from each of excitation light sources 40 is converted into collimated light through its corresponding first lens 31. The collimated light converted from excitation light 82 passes through dichroic mirror 34, and converges on wavelength converter 4 of wavelength conversion element 1 through projection lens 33. At this time, dichroic mirror 34 according to the present embodiment also functions as a polarization beam splitter. Among the light components having a wavelength near that of the excitation light, dichroic mirror 34 allows only those which enter as p-wave components to pass through. Dichroic mirror 34 is designed so as to reflect the excitation light which enters as s-wave components and light components having a wavelength longer than that of the excitation light. In the present embodiment, wavelength converter 4 is irradiated with excitation light 82 using the plurality of excitation light sources 40. Excitation light 82 is scattered by projections 5a and depressions 5b formed of first fluorescent particles 4a and transparent binder 4b on the surface (incident surface 6) of wavelength converter 4. Non-polarized first radiation light 85 and fluorescent second radiation light 91 radiated from wavelength converter 4 are radiated as white radiation light 95 from wavelength conversion element 1. Radiation light 95 is converted into collimated light through projection lens 33, is partially or totally reflected on dichroic mirror 34, and is radiated as radiation light 95 from light emitting device 201.

In such a configuration, wavelength converter 4 of light emitting device 201 can radiate white light having reduced unevenness in chromaticity distribution according to the emitting direction, and wavelength converter 4 can be irradiated with excitation light 82 using the plurality of excitation light sources 40. For these reasons, the configuration can generate radiation light having high luminance. Because the configuration includes a single lens which functions as a lens for irradiating wavelength converter 4 with excitation light 82 and a lens for converting white light radiated from wavelength converter 4 into white light having high directivity, the light emitting device can have a simple configuration.

Although white light is radiated from wavelength converter 4 in the present embodiment, for example, using a semiconductor laser which radiates laser light having a wavelength of 390 nm to 500 nm as excitation light source 40 of light emitting device 201 and YAG fluorescent particles which radiate fluorescence having a peak wavelength near 560 nm as first fluorescent particles 4a, light emitting device 201 can have any other configuration. For example, light emitting device 201 may include first fluorescent particles 4a of a cerium-doped (Ga,Y)₃Al₅O₁₂ fluorescent substance, a cerium-doped (Lu,Y)₃Al₅O₁₂ fluorescent substance, an europium-doped SiAlON fluorescent substance, or an europium-doped (Sr,Ca)AlSiN fluorescent substance, and may radiate the radiation light having a main wavelength in the range of green or red light and having a small intensity distribution at the emitting direction angle of blue light to be mixed.

Furthermore, wavelength converter 4 may revolve about the central axis to enhance heat dissipating properties of wavelength converter 4.

Such a light source device can be used as a light source for projectors, for example.

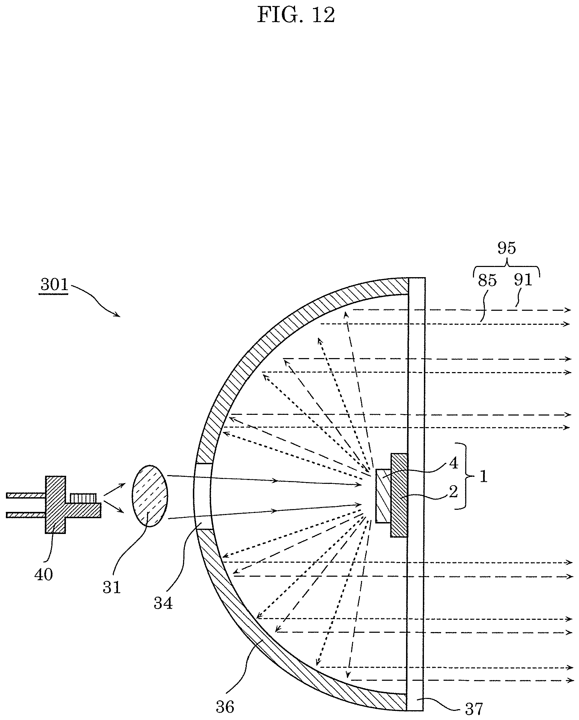

Another example of the configuration of the light emitting device according to the present disclosure, i.e., light emitting device 301 will now be described with reference to FIG. 12.

FIG. 12 is a schematic view illustrating another example of the configuration of the light emitting device including wavelength conversion element 1 according to the present embodiment.

As illustrated in FIG. 12, light emitting device 301 of this example configuration includes wavelength conversion element 1, excitation light source 40, first lens 31, reflecting mirror 36, and transparent cover member 37.

Reflecting mirror 36 is a curved mirror having a paraboloidal inner surface. Wavelength conversion element 1 is disposed on the focus of the paraboloidal surface formed by reflecting mirror 36.

In FIG. 12, the excitation light emitted from excitation light source 40 is converted into collimated light through first lens 31, passes through dichroic mirror 34 of reflecting mirror 36, and converges on wavelength converter 4 of wavelength conversion element 1. Here, dichroic mirror 34 is a mirror which allows transmission of excitation light and reflection of fluorescence. The excitation light is scattered on the surface of wavelength converter 4 by projections 5a and depressions 5b formed of first fluorescent particles 4a and transparent binder 4b. First radiation light 85 and second radiation light 91 are then radiated from wavelength converter 4, and are radiated as white radiation light 95 from wavelength conversion element 1. Radiation light 95 is reflected on reflecting mirror 36, passes through transparent cover member 37, and is radiated as substantially parallel radiation light 95 from light emitting device 301.

In such a configuration, wavelength converter 4 of the light emitting device radiates white light having reduced unevenness in chromaticity distribution according to the emitting direction, and excitation light source 40 can be disposed at a position different from that of wavelength conversion element 1. For this reason, light emitting device 401 can be designed with higher freedom. Although the configuration includes reflecting mirror 36 having a paraboloidal inner surface, reflecting mirror 36 can have an inner surface of any other shape. The shape of the inner surface of reflecting mirror 36 may be appropriately determined according to the required intensity distribution in radiation light 95.

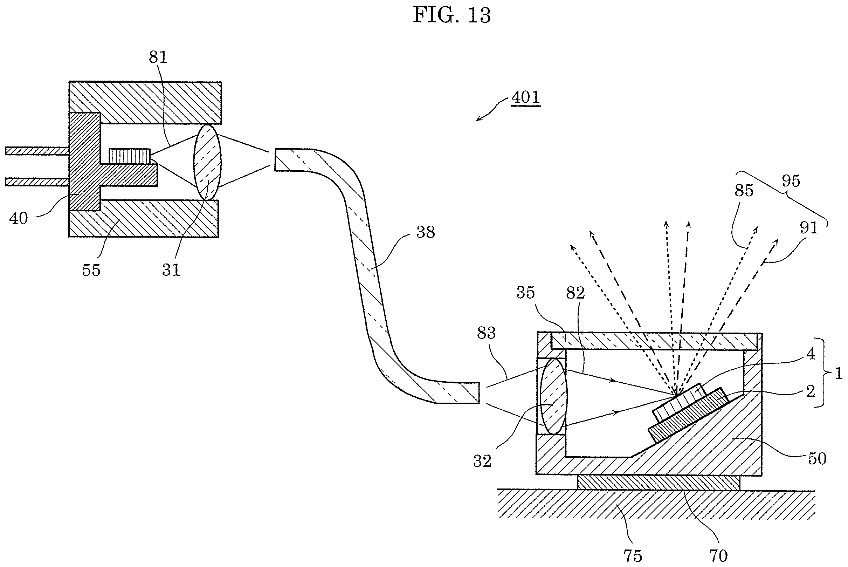

Another example of the configuration of the light emitting device according to the present disclosure, i.e., light emitting device 401 will now be described with reference to FIG. 13.

FIG. 13 is a schematic view illustrating another example of the configuration of the light emitting device including wavelength conversion element 1 according to the present embodiment.

As illustrated in FIG. 13, light emitting device 401 includes excitation light source 40, holder 55, first lens 31, second lens 32, optical fiber 38, fixing member 50, heat dissipating mechanism 70, and wavelength conversion element 1.

As illustrated in FIG. 13, excitation light source 40 with first lens 31 is held in holder 55. Wavelength conversion element 1 is fixed to fixing member 50, and is enclosed with second lens 32 and transparent cover member 35.

Excitation light 81 emitted from excitation light source 40 converges on optical fiber 38 through first lens 31, and propagates through optical fiber 38. Excitation light 83 emitted from optical fiber 38 passes through second lens 32 to be converged as excitation light 82, and is emitted to wavelength converter 4 of wavelength conversion element 1. Excitation light 82 is then scattered on the surface (incident surface 6) of wavelength converter 4 by projections 5a and depressions 5b formed of first fluorescent particles 4a and transparent binder 4b. Scattered excitation light 82 is radiated as first radiation light 85 and second radiation light 91 radiated in all directions in wavelength converter 4. First radiation light 85 and second radiation light 91 are then radiated as white radiation light 95 from wavelength conversion element 1.

In such a configuration, wavelength converter 4 of light emitting device 401 radiates white light having reduced unevenness in chromaticity distribution according to the emitting direction, and fixing member 50 can be separated from the heat generated in holder 55 including excitation light source 40, which is a heating body different from wavelength converter 4. Because such a configuration can prevent an increase in temperature of wavelength converter 4, a reduction in conversion efficiency caused by an increase in temperature of first fluorescent particles 4a can be prevented, enabling radiation of light having higher luminance.

### (Modification 1 of Embodiment 1)

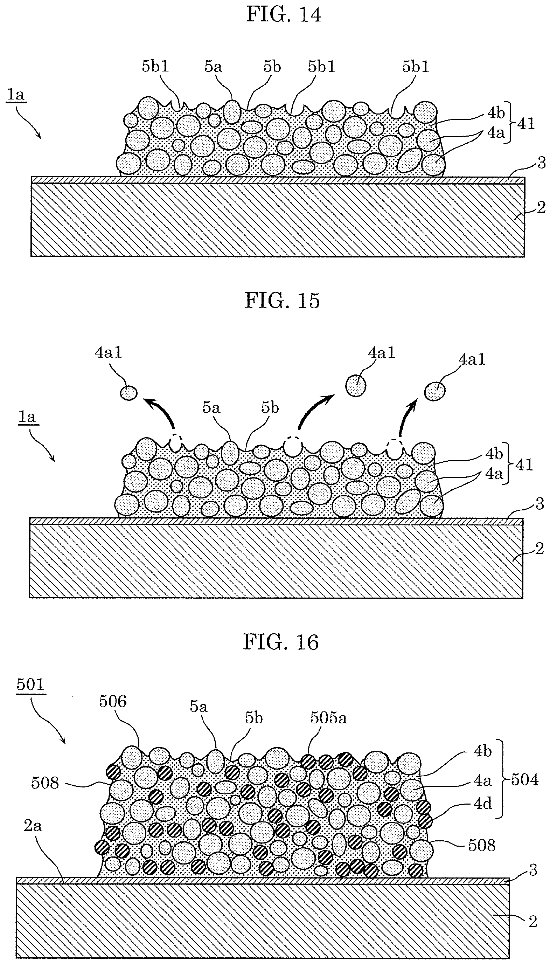

Wavelength conversion element according to Modification 1 of Embodiment 1 will now be described with reference to FIGs. 14 and 15. The wavelength conversion element according to the present modification includes a wavelength converter having a different surface structure from that of wavelength conversion element 1 according to Embodiment 1.

FIG. 14 is a schematic cross-sectional view of wavelength conversion element 1a according to the present modification.

FIG. 15 is a diagram illustrating a process of manufacturing wavelength conversion element 1a according to the present modification.

As illustrated in FIG. 15, wavelength conversion element 1a according to the present modification includes wavelength converter 41 from which part of first fluorescent particles 4a1 disposed on the surface of wavelength converter 4 in wavelength conversion element 1 according to Embodiment 1 is removed. In other words, first fluorescent particles 4a are not exposed from the inner surface of at least one of the depressions in wavelength converter 41. As a result, depressions 5b1 having an opening having a diameter equal to that of first fluorescent particles 4a are formed in transparent binder 4b. Depressions 5b1 have a diameter of 6 µm or more and 15 µm or less, for example. Depressions 5b1 have a depth smaller than the diameter of first fluorescent particles 4a and substantially equal to the radius of first fluorescent particles 4a at the maximum.

Depressions 5b1 may be formed by another process which can form depressions having a depth and an opening diameter substantially equal to those of depressions 5b1 formed after removal of first fluorescent particles 4a. For example, depressions 5b1 may be formed by pressing a mold by nanoimprint lithography. As a result, as illustrated in FIG. 14, depressions 5b1 formed of transparent binder 4b are formed on the surface of wavelength conversion element 1a. Such depressions 5b1 can provide enhanced scattering action to excitation light 96. As a result, the uniformity of the radiation light radiated from wavelength conversion element 1a can be enhanced.

### (Modification 2 of Embodiment 1)

The wavelength conversion element according to Modification 2 of Embodiment 1 will now be described with reference to FIG. 16. In the wavelength conversion element according to the present modification, the wavelength converter includes second particles in addition to first fluorescent particles 4a and transparent binder 4b.

FIG. 16 is a schematic cross-sectional view of wavelength conversion element 501 according to the present modification.

As illustrated in FIG. 16, wavelength conversion element 501 according to the present modification includes wavelength converter 504 including first fluorescent particles 4a and second particles 4d mixed and dispersed in transparent binder 4b. Second particles 4d are transparent nanoparticles of silica (SiO₂) or alumina (Al₂O₃), for example.

As the present modification, mixing of second particles 4d besides first fluorescent particles 4a in wavelength converter 504 can reduce the content of first fluorescent particles 4a in wavelength converter 504, and can increase the thickness of wavelength converter 4. In other words, the wavelength converter can have an increased thickness without changing the wavelength conversion efficiency in the wavelength converter. For example, the content (vol %) of first fluorescent particles 4a can be controlled to be 30%, and the thickness of wavelength converter 504 can be controlled to be 60 µm. As a result, wavelength converter 504 can have a thickness larger than that in Embodiment 1, reducing unevenness in color of the radiation light caused by a variation in thickness of wavelength converter 504.

In the present modification, the content of first fluorescent particles 4a can be reduced, and increases in content and proportion of transparent binder 4b in wavelength converter 504 can be prevented. As a result, the generation of crack in wavelength converter 504 can be prevented even when transparent binder 4b to be used is a material whose volume contracts during curing. Furthermore, projections 5a and 505a and depressions 5b can be formed with second particles 4d on the surface of wavelength converter 504. For example, by using silica nanoparticles or alumina nanoparticles as second particles 4d and silsesquioxane as transparent binder 4b, and utilizing the difference in etching rate, projections 5a and 505a and depressions 5b can be formed on the surface of wavelength converter 504. In other words, both projections 5a formed of first fluorescent particles 4a exposed from the vertices and projections 505a formed of second particles 4d exposed from the vertices can be formed on incident surface 506 and lateral surface 508 of wavelength converter 504. In this case, second particles 4d preferably have a particle diameter of 2 µm or more and 10 µm or less. In the case where silica nanoparticles, which have a refractive index close to that of transparent binder 4b, are used as second particles 4d, such silica nanoparticles do not reduce the conversion efficiency of excitation light into fluorescence in first fluorescent particles 4a.

Wavelength conversion element 501 according to the present modification also can ensure sufficient scattering action as in wavelength conversion element 1 according to Embodiment 1.

Although an example has been described in which transparent nanoparticles are used as second particles 4d, second particles 4d can be formed of any other material than the transparent nanoparticles. For example, first fluorescent particles 4a may be a yellow fluorescent substance, and second particles 4d may be a blue fluorescent substance. Use of these fluorescent substances can result in wavelength conversion element 501 which can radiate white light through irradiation with blue violet excitation light having a wavelength of 400 nm to 430 nm.

### (Embodiment 2)

The wavelength conversion element according to Embodiment 2 will now be described. The wavelength conversion element according to the present embodiment includes a wavelength converter including depressions and projections formed of first fluorescent particles and a transparent binder on the surface of the wavelength converter using a transparent binder containing a transparent material containing zinc oxide of zinc (Zn) and oxygen (O) as a main component. In the present embodiment, the transparent binder is filled into gaps between first fluorescent particles in an aqueous solution to form the projections and depressions formed of the first fluorescent particles and the transparent binder on the surface of the wavelength converter. Specifically, as in Embodiment 1, the wavelength converter includes the projections formed of the exposed surfaces of the first fluorescent particles and the depressions formed of exposed surfaces of the transparent binder between the first fluorescent particles.

Because this configuration enables use of a material for a transparent binder having a thermal conductivity higher than that of SiOx, the wavelength conversion element can be irradiated with incident light having larger light output. Accordingly, use of the wavelength conversion element according to the present embodiment can achieve a light emitting device having higher luminance. Furthermore, the depressions and projections which are formed of the first fluorescent particles and the transparent binder and scatter incident light are formed on the surface of the wavelength converter. Such a configuration can achieve a light emitting device having high luminance and small emitting angle dependency of the chromaticity of radiation light.

The wavelength conversion element according to Embodiment 2 including non-essential components will be specifically described with reference to the drawings below.

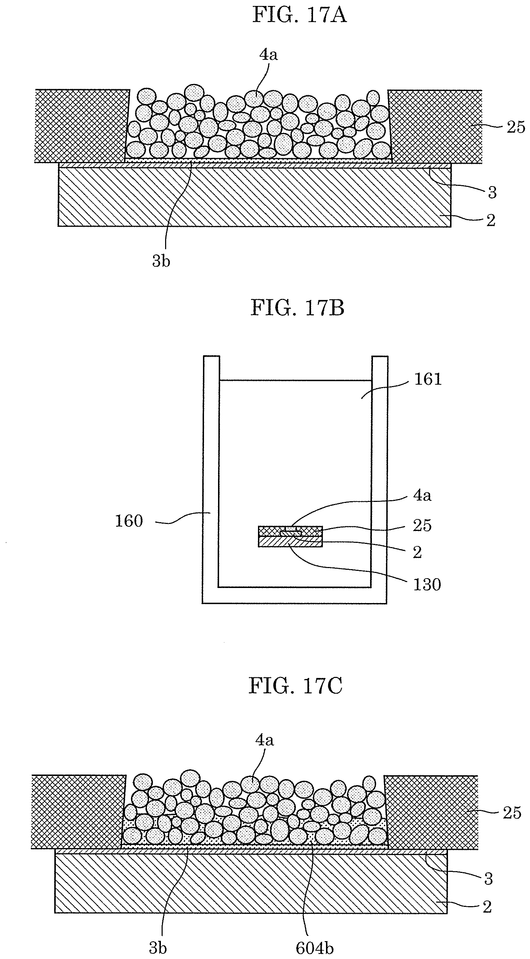

FIG. 17A is a schematic cross-sectional view illustrating a step in a process of manufacturing of the wavelength conversion element according to the present embodiment before filling of the transparent binder.

FIG. 17B is a schematic cross-sectional view illustrating a process of filling the transparent binder in the process of manufacturing the wavelength conversion element according to the present embodiment.

FIG. 17C is a schematic cross-sectional view illustrating a step of filling transparent binder 604b in the process of manufacturing the wavelength conversion element according to the present embodiment.

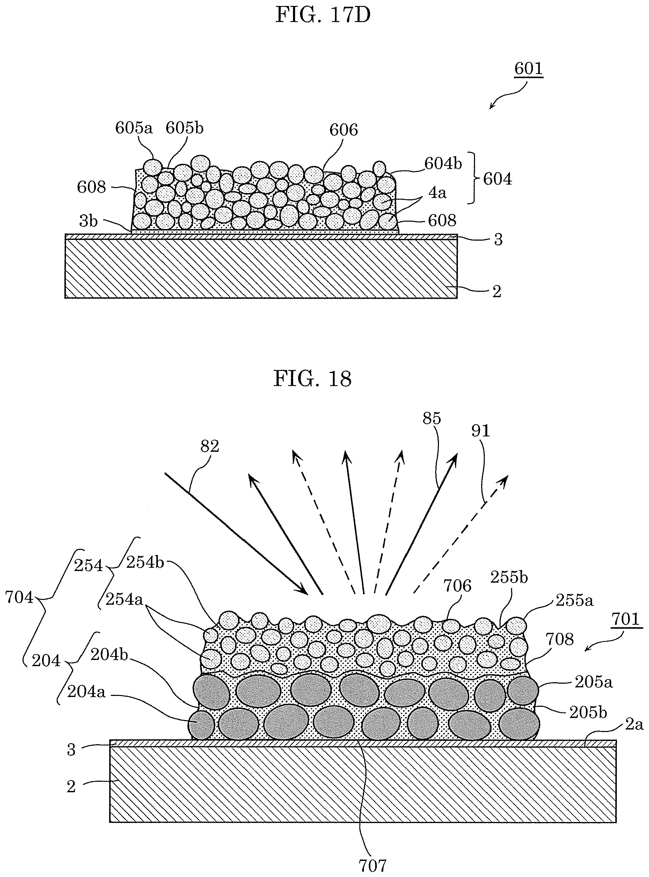

FIG. 17D is a schematic cross-sectional view illustrating a step after the filling of transparent binder 604b in the process of manufacturing wavelength conversion element 601 according to the present embodiment.

Wavelength conversion element 601 according to the present embodiment is manufactured as illustrated in FIGs. 17A to 17D below.

First, as illustrated in FIG. 17A, reflective film 3 is formed on support member 2, and thin film 3b formed of zinc oxide and having a c-axis orientation is formed above reflective film 3 by sputtering, for example. Thin film 3b may be formed across the entire surface of reflective film 3 following the formation of reflective film 3, or as illustrated in FIG. 17A, thin film 3b may be formed by patterning on in a region where wavelength converter 604 is formed.

In the next step, aggregates of first fluorescent particles 4a are formed in the opening, in which wavelength converter 604 is formed, using mask 25 with openings.

In the next step, as illustrated in FIG. 17B, solution case 160 is filled with solution 161, which is an aqueous solution of zinc nitrate (Zn(NO₃)₂) containing hexamethylenetetrameine (C₆H₁₂N₄), for example. Subsequently, as illustrated in FIG. 17B, support member 2 and first fluorescent particles 4a illustrated in FIG. 17A are placed on jig stand 130 disposed in solution 161, and zinc oxide is grown from thin film 3b to form transparent binder 604b by solution growth. At this time, as illustrated in FIG. 17C, zinc oxide grows upwardly from thin film 3b using thin film 3b as a seed crystal while filling the gaps, which are formed by first fluorescent particles 4a in the first fluorescent particles layer. As illustrated in FIG. 17D, solution growth is terminated immediately before first fluorescent particles 4a on the topmost surface are buried in zinc oxide. This process can form a structure having depressions and projections formed of first fluorescent particles 4a and transparent binder 604b (zinc oxide) on the surface of wavelength converter 604, specifically, projections 605a formed of exposed surfaces of first fluorescent particles 4a and depressions 605b formed of exposed surfaces of transparent binder 604b between first fluorescent particles 4a. In the present embodiment, projections 605a and depressions 605b are formed only on incident surface 606, which is a surface disposed above wavelength converter 604. Projections 605a and depressions 605b are not formed on lateral surface 608.

The process can facilitate the manufacturing of wavelength conversion element 601 according to the present embodiment. Because the zinc oxide subjected to solution growth has a thermal conductivity of about 5 W/m·K, which is much higher than that of glass (about 1 W/m·K), the zinc oxide can quickly absorb and dissipate heat generated in wavelength converter 604. As a result, wavelength conversion element 601 can radiate white light having high luminance and reduced unevenness in chromaticity distribution according to the emitting direction.

In the present embodiment, wavelength converter 604 may further contain second particles. The second particles contained in wavelength converter 604 can provide the same advantageous effects as in Modification 2 of Embodiment 1.

### (Embodiment 3)

The wavelength conversion element according to Embodiment 3 will now be described with reference to the drawings. In the wavelength conversion element according to the present embodiment, the wavelength converter includes a first wavelength conversion member including first fluorescent particles and a transparent binder, and a second wavelength conversion member which is disposed between the first wavelength conversion member and a supporting surface, and is different from the first wavelength conversion member.

FIG. 18 is a schematic cross-sectional view of wavelength conversion element 701 according to the present embodiment.

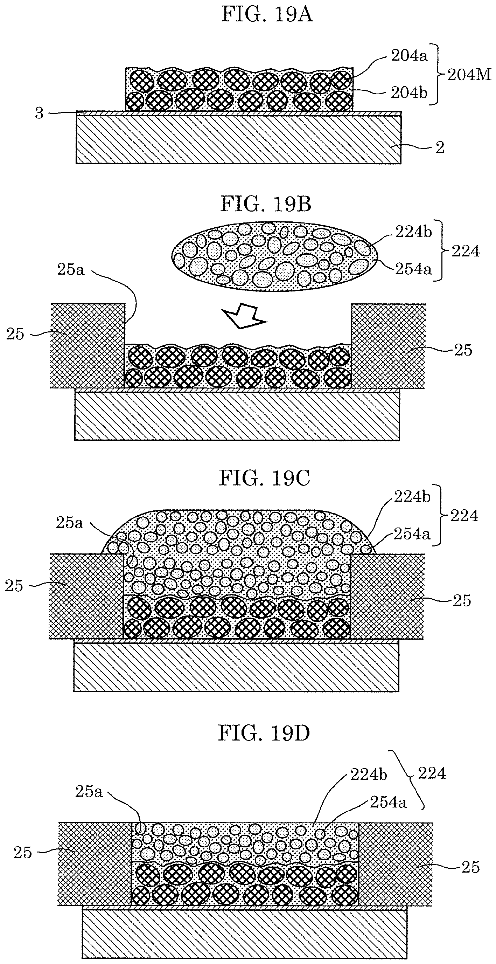

FIGs. 19A to 19F are schematic cross-sectional views illustrating steps of a process of manufacturing the wavelength conversion element according to the present embodiment.

As illustrated in FIG. 18, in wavelength conversion element 701 according to the present embodiment, wavelength converter 704 includes first wavelength conversion member 254 including first fluorescent particles 254a and transparent binder 254b. Wavelength converter 704 further includes second wavelength conversion member 204 which is disposed between first wavelength conversion member 254 and supporting surface 2a of support member 2, and is different from first wavelength conversion member 254. In the present embodiment, second wavelength conversion member 204 contains second fluorescent particles 204a and transparent binder 204b.

Wavelength converter 704 has joint surface 707 facing supporting surface 2a, and incident surface 706 disposed opposite to joint surface 707, excitation light entering incident surface 706. Wavelength converter 704 has lateral surface 708 intersecting joint surface 707 and incident surface 706. In the present embodiment, projections 255a and depressions 255b formed of first fluorescent particles 254a and transparent binder 254b are formed on incident surface 706. Lateral surface 708 includes projections 205a and depressions 205b formed of second fluorescent particles 204a and transparent binder 204b in addition to projections 255a and depressions 255b.

In wavelength conversion element 701 according to the present embodiment, for example, use of first fluorescent particles 254a which radiate fluorescence having a predetermined wavelength and second fluorescent particles 204a which radiate fluorescence having a wavelength different from the predetermined wavelength can increase the freedom in design of the spectrum of white light to be emitted from wavelength conversion element 701, and can reduce the unevenness in chromaticity distribution according to the emitting direction.

A specific process of manufacturing wavelength conversion element 701 including non-essential processes will now be described with reference to FIGs. 19A to 19F.

As illustrated in FIG. 19A, second wavelength conversion base 204M including second fluorescent particles 204a and transparent binder 204b are fixed onto support member 2 by the same process as in Embodiment 1. At this time, the surface of second wavelength conversion base 204M may be wet etched. That is, projections and depressions formed of second fluorescent particles 204a and transparent binder 204b may be formed.

As illustrated in FIG. 19B, mask 25 with openings is then disposed. Mask 25 has openings 25a formed in consideration of a thickness for forming first wavelength conversion member 254. As illustrated in FIG. 19C, fluorescent paste 224 containing a mixture of first fluorescent particles 254a and liquid transparent binder 224b is then injected into openings 25a such that openings 25a are sufficiently filled.

As illustrated in FIG. 19D, excess fluorescent paste 224 overflowing from openings 25a is removed.

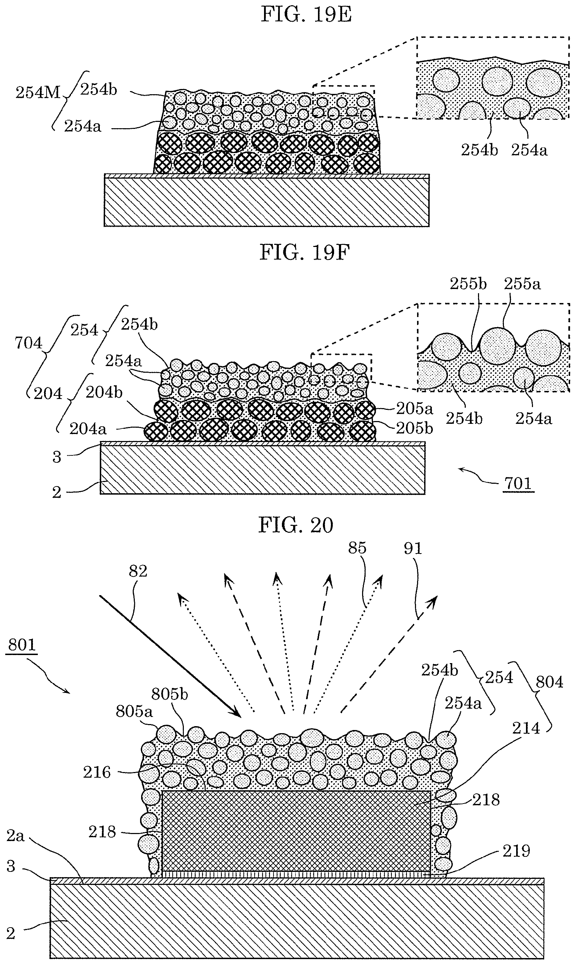

As illustrated in FIG. 19E, the mask with openings is removed, and support member 2 including fluorescent paste 224 formed into a predetermined shape on the surface of support member 2 is treated at high temperature. As a result, first wavelength conversion base 254M is formed on second wavelength conversion base 204M. Subsequently, first wavelength conversion base 254M and second wavelength conversion base 204M illustrated in FIG. 19E are immersed in a buffered aqueous solution of hydrofluoric acid, and are subjected to isotropic wet etching to etch only transparent binders 254b and 204b. By isotropic wet etching, projections 255a and depressions 255b formed of first fluorescent particles 254a and transparent binder 254b are formed on incident surface 706 and lateral surface 708 of wavelength converter 704 as illustrated in FIG. 19F. Projections 205a and depressions 205b formed of second fluorescent particles 204a and transparent binder 204b are also formed on lateral surface 708 of wavelength converter 704. Also in the present embodiment, projections 255a and 205a formed of exposed surfaces of first fluorescent particles 254a and second fluorescent particles 204a, respectively, are formed as in Embodiments 1 and 2. For this reason, wavelength conversion element 701 according to the present embodiment can also ensure sufficient scattering action.

The manufacturing process can facilitate the manufacturing of wavelength conversion element 701 having a plane including depressions and projections formed of the fluorescent particles and the transparent binder on the surface of wavelength converter 704 even when wavelength converter 704 including layers of fluorescent particles of different types is used.

As described above, in the case where a fluorescent substance which radiates fluorescence having a predetermined wavelength and another fluorescent substance which radiates another fluorescence having a wavelength different from the predetermined wavelength are used as first fluorescent particles 254a and second fluorescent particles 204a, respectively, first fluorescent particles 254a are formed of a red fluorescent substance, and second fluorescent particles 204a are formed of a yellow fluorescent substance, for example. In this case, light having a wavelength of 430 nm to 480 nm can be used as excitation light. Alternatively, light having a wavelength of 400 nm to 430 nm can be used as excitation light, a blue fluorescent substance as first fluorescent particles 254a, and a yellow fluorescent substance as second fluorescent particles 204a.

Furthermore, first fluorescent particles 254a and second fluorescent particles 204a may be fluorescent substances having different particle diameter distributions. Such a configuration can increase the freedom in design of depressions and projections on the surface of wavelength converter 704.

### (Modification of Embodiment 3)

The wavelength conversion element according to a modification of Embodiment 3 will now be described. Unlike wavelength conversion element 701 according to Embodiment 3, the wavelength conversion element according to the present modification contains a fluorescent ceramic substance as a material for second wavelength conversion member. The configuration of the present modification is substantially identical to that of Embodiment 3, and only differences will be described with reference to the drawings.

FIG. 20 is a schematic cross-sectional view of wavelength conversion element 801 according to the present modification.

Similarly to wavelength conversion element 701 according to Embodiment 3, wavelength conversion element 801 according to the present modification includes two wavelength conversion members formed of different fluorescent materials and stacked on support member 2. Unlike wavelength conversion element 701 according to Embodiment 3, in wavelength conversion element 801 according to the present modification, at least a second wavelength conversion member is formed with a different fluorescent ceramic member. Because a fluorescent ceramic member having a higher thermal conductivity is used as part of wavelength converter 804 in wavelength conversion element 801 according to the present modification, heat generated in wavelength converter 804 can be efficiently conducted to support member 2. In wavelength conversion element 801 according to the present modification, top surface 216 of second wavelength conversion member 214 and lateral surface 218 thereof intersecting supporting surface 2a are covered with first wavelength conversion member 254. Accordingly, projections 805a and depressions 805b formed of first fluorescent particles 254a and transparent binder 254b are formed on the surface of wavelength converter 804. For this reason, a plane of depressions and projections which can effectively scatter excitation light can be formed on the surface of wavelength converter 804 without processing the surface of the fluorescent ceramic member. Although fine depressions and projections formed during manufacturing of the fluorescent ceramic member are present on the surface of the fluorescent ceramic member, these fine depressions and projections are much smaller than the depressions and projections formed on the surface of the wavelength converter according to the present embodiment. For this reason, these fine depressions and projections are omitted in the drawings. As a result, wavelength conversion element 801 having reduced unevenness in chromaticity distribution according to the emitting direction and having high luminance can be achieved.

Wavelength conversion element 801 according to the present modification is implemented by the configuration and the manufacturing process specifically described below. Reflective film 3, which is a laminate film of Ti, Pt, and Au, for example, is formed on supporting surface 2a of support member 2. A fluorescent ceramic member or second wavelength conversion member 214 is fixed onto reflective film 3 using bonding material 219, such as AuSn. Here, for example, second wavelength conversion member 214 is formed of polycrystals of a YAG fluorescent substance having a thickness of about 20 µm or more and 200 µm or less and having an outer shape of a square of about 0.6 mm.

In the present modification, first wavelength conversion member 254 is formed as follows. First, a mask with openings slightly larger than second wavelength conversion member 214 is disposed on support member 2 bonded to second wavelength conversion member 214 so as to surround second wavelength conversion member 214. Fluorescent paste 224 is then injected into the portions surrounded with the mask with openings. The subsequent manufacturing steps are the same as those in wavelength conversion element 701 according to Embodiment 3. By this process, first wavelength conversion member 254 is formed so as to cover the surfaces excluding the surface facing support member 2 among the surfaces of second wavelength conversion member 214 formed with a fluorescent ceramic member. Projections 805a and depressions 805b are formed on the surface of first wavelength conversion member 254.

The process described above can facilitate manufacturing of wavelength conversion element 801 according to the present modification.

### (Embodiment 4)

The wavelength conversion element according to Embodiment 4 will now be described. The wavelength conversion element according to the present embodiment has the same structure as that of wavelength conversion element 1 according to Embodiment 1. In Embodiment 4, wavelength conversion element 1 can be more readily manufactured. Only differences between Embodiments 1 and 4 will be described below.

Wavelength conversion element 1 according to the present embodiment has a configuration similar to that of Embodiment 1 illustrated in the schematic cross-sectional view in FIG. 1.

Wavelength converter 4 contains first fluorescent particles 4a which absorb excitation light and generate fluorescence, and transparent binder 4b which bonds first fluorescent particles 4a, and has incident surface 6 which excitation light enters. At this time, among the surfaces of wavelength converter 4, at least incident surface 6 includes projections 5a formed as a result of exposure of first fluorescent particles 4a, and depressions 5b formed as a result of exposure of transparent binder 4b. The surface of one first fluorescent particle 4a is exposed from the vertex of projection 5a.

Here, first fluorescent particles 4a are fluorescent particles of a yttrium-aluminum-garnet (YAG) fluorescent substance, such as cerium (Ce)-doped (Ga, Y, Gd)₃Al₅O₁₀.

First fluorescent particles 4a used had a particle diameter distribution from 6 µm to 15 µm. Here, a particle diameter distribution from 6 µm to 15 µm means that the average particle diameter (median diameter) D50 is 9 µm, the average particle size D10 is 6 µm, and the average particle size D90 is 15 µm.

In the present embodiment, transparent binder 4b containing, as a main component, silicone represented by Formula (R₂SiO₂)ₙ (where R is an organic group) having a D unit as a siloxane bond, or transparent binder 4b containing, as a main component, silsesquioxane represented by Formula (RSiO_{1.5})ₙ (where R is an organic group) and having a T unit as a siloxane bond can be selected. At this time, use of silsesquioxane as a main component is preferred because silsesquioxane having a T unit as a siloxane bond barely decomposes by excitation light having high light density. For example, in the case where a light emitting device including wavelength conversion element 1 including wavelength converter 4 containing silsesquioxane as a main component of transparent binder 4b is continuously operated for 2000 hours or longer, a change in properties of wavelength converter 4 can be reduced compared to the case where silicone is used as transparent binder 4b.

Although the case where silsesquioxane is contained as transparent binder 4b has been described in the present embodiment, a silsesquioxane having the following structure is preferably used. Examples of silsesquioxane represented by Formula (RSiO_{1.5})ₙ (where R is an organic group) include silsesquioxane where R is a methyl group (Methyl) represented by CH₃, and silsesquioxane where R is a phenyl group (Phenyl) represented by C₆H₅. More preferred is silsesquioxane where R is a methyl group (Methyl) represented by CH₃. Compared to the silsesquioxane having a phenyl group, the silsesquioxane having a methyl group is barely decomposed by excitation light having high light density. For example, use of wavelength converter 4 including transparent binder 4b containing the silsesquioxane having a methyl group can achieve a light emitting device having small changes in properties of wavelength converter 4 even after continuous operation for 2000 hours or longer.

A more preferred embodiment of the process of manufacturing wavelength conversion element 1 will now be described. Although a process by wet etching has been described as the process of forming projections 5a and depressions 5b formed of first fluorescent particles 4a and transparent binder 4b on the surface of first wavelength conversion base 4M in Embodiment 1, any process of manufacturing wavelength conversion element 1 can be used. For example, fluorescent paste 24 of first fluorescent particles 4a dispersed in a transparent binder prepared by dissolving silsesquioxane in an organic solvent is applied onto support member 2, is kept for a predetermined time under an atmosphere at a low atmospheric pressure, and is heat-treated. Thereby, projections 5a and depressions 5b formed of first fluorescent particles 4a and transparent binder 4b can be formed on the surface of first wavelength conversion base 4M. As a result, wavelength conversion element 1 having luminous intensity distribution properties equivalent to those in graph (c) of FIG. 8 can be obtained. At this time, the content of first fluorescent particles 4a (vol%) in wavelength converter 4 is preferably 40 vol% to 70 vol%.

Although first fluorescent particles 4a having a particle diameter having a distribution of 6 µm to 15 µm has been used, first fluorescent particles 4a can have any particle diameter. Wavelength conversion element 1 having a desired surface shape can be provided by manufacturing wavelength conversion element 1 by the manufacturing process described above using fluorescent particles having an average particle size (median diameter) D50 of 3 µm or more and 20 µm or less as first fluorescent particles 4a.

### (Other modifications)

Although the wavelength conversion element and the light emitting device according to the present disclosure have been described based on the embodiments, these embodiments should not be construed as limitative to the present disclosure.

For example, although the configuration including two wavelength conversion members has been described in Embodiment 3, the configuration may include three or more wavelength conversion members. Such a configuration can further increase the freedom in design of the distribution of the wavelength of the radiation light.

Because a thin film having a sufficiently small thickness than the wavelength of the excitation light, such as a thin film having a wavelength equal to or less than 1/5 of that of excitation light, can be optically ignored, the surfaces of the fluorescent particles may be coated with a transparent binder having a thickness equal to or less than 1/5 of the wavelength of excitation light in the incident surface of the wavelength converter.

Besides, embodiments obtained through a variety of modifications of these embodiments conceived by those skilled in the art and embodiments implemented with any combination of components and functions in the embodiments without departing from the gist of the present disclosure are also included in the present disclosure.

### INDUSTRIAL APPLICABILITY

The wavelength conversion element according to the present disclosure can ensure sufficient scattering action as described above. The light emitting device including the wavelength conversion element has high luminance and small emitting angle dependency of luminous intensity distribution. For this reason, the wavelength conversion element according to the present disclosure and the light emitting device including the wavelength conversion element are useful in a variety of lighting apparatuses and devices, such as headlamps for vehicles and light sources for spotlights.

### REFERENCE MARKS IN THE DRAWINGS

1, 1a, 501, 601, 701, 801 wavelength conversion element
2 support member
2a supporting surface
2b peripheral portion
3 reflective film
3b thin film
4, 41, 504, 604, 704, 804 wavelength converter
4a, 4a1, 254a first fluorescent particles
4b, 24b, 204b, 224b, 254b transparent binder
4d second particles
4e vertex
4M, 254M first wavelength conversion base
5a, 205a, 255a, 505a, 605a, 805a projections
5b, 5b1, 205b, 255b, 605b, 805b depressions
6, 506, 606, 706 incident surface
7, 707 joint surface
8, 508, 608, 708, 218 lateral surface
11 contact member
12 holding member
12a through hole
12b end
13 screw
24, 224 fluorescent paste
25 mask with openings
25a opening
31 first lens
32 second lens
33 projection lens
34 dichroic mirror
35, 37 transparent cover member
36 reflecting mirror
38 optical fiber
40 excitation light source
50 fixing member
50a screw hole
55 holder
58 screw
60, 201, 301, 401 light emitting device
70 heat dissipating mechanism
75 external fixing base
81, 82, 83, 96 excitation light
85, 97, 98 first radiation light
91 second radiation light
95 radiation light
99 detector
101 projector
130 jig stand
160 solution case
161 solution
204, 214 second wavelength conversion member
204a second fluorescent particles
204M second wavelength conversion base
216 top surface
219 bonding material
254 first wavelength conversion member
L1, L2 width

## Claims

1. A wavelength conversion element, comprising:
a support member having a supporting surface; and
a wavelength converter disposed above the supporting surface,
wherein the wavelength converter contains first fluorescent particles which absorb excitation light and generate fluorescence, and a transparent binder which bonds the first fluorescent particles, and has a joint surface facing the supporting surface, and an incident surface disposed opposite to the joint surface, the excitation light entering the incident surface,
the excitation light and the fluorescence are emitted from the incident surface,
the wavelength converter includes projections,
at least part of the projections is disposed on the incident surface, and
the first fluorescent particles are partially exposed from vertices of the projections.

2. The wavelength conversion element according to claim 1,
wherein the transparent binder contains silsesquioxane or zinc oxide.

3. The wavelength conversion element according to claim 1 or 2,
wherein the wavelength converter includes depressions, and
the transparent binder is exposed from the depressions.

4. The wavelength conversion element according to claim 3,
wherein the first fluorescent particles are not exposed from an inner surface of at least one of the depressions.

5. The wavelength conversion element according to claim 4,
wherein at least one of the depressions has a diameter of 5 µm or more and 16 µm or less.

6. The wavelength conversion element according to any one of claims 3 to 5,
wherein the incident surface has a region where the projections and the depressions have a peak to valley (P-V) value in a range of 4.4 times to 8.9 times a peak wavelength of the excitation light.

7. The wavelength conversion element according to any one of claims 3 to 6,
wherein the incident surface has a region where the projections and the depressions have a peak to valley (P-V) value in a range of 2 µm to 4 µm.

8. The wavelength conversion element according to any one of claims 1 to 7,
wherein the wavelength converter has a lateral surface intersecting the joint surface and the incident surface, and
at least part of the projections is disposed on the lateral surface.

9. The wavelength conversion element according to any one of claims 1 to 8,
wherein in a top surface view of the supporting surface, a peripheral portion of the support member is exposed from the wavelength converter.

10. The wavelength conversion element according to any one of claims 1 to 9,
wherein a reflective film is disposed on the supporting surface.

11. The wavelength conversion element according to any one of claims 1 to 10,
wherein the wavelength converter includes a first wavelength conversion member including the first fluorescent particles and the transparent binder, and a second wavelength conversion member which is disposed between the first wavelength conversion member and the supporting surface and is different from the first wavelength conversion member.

12. The wavelength conversion element according to claim 11,
wherein the second wavelength conversion member is formed of a fluorescent ceramic, and
among surfaces of the second wavelength conversion member, a lateral surface intersecting the supporting surface is covered with the first wavelength conversion member.

13. The wavelength conversion element according to any one of claims 1 to 12,
wherein in the top surface view of the supporting surface, a periphery of the wavelength converter has a vertex having an internal angle of more than 180 degrees.

14. A light emitting device, comprising:
the wavelength conversion element according to any one of claims 1 to 13; and
an excitation light source which radiates the excitation light.

15. The light emitting device according to claim 14, further comprising:
a fixing member which fixes the wavelength conversion element,
wherein the wavelength conversion element is fixed to the fixing member with a holding member disposed on a peripheral portion of the supporting surface.

16. The light emitting device according to claim 14 or 15, further comprising:
a lens disposed between the excitation light source and the wavelength conversion element.
